Europäisches Patentamt

European Patent Office

Office européen des brevets

(19)

(11) EP 1 126 281 A2

(12) EUROPEAN PATENT APPLICATION

(43) Date of publication:
22.08.2001 Bulletin 2001/34

(51) Int Cl.⁷: **G01R 19/15**

(21) Application number: 00310206.8

(22) Date of filing: 16.11.2000

| | |
|---|---|
| (84) Designated Contracting States:<br>**AT BE CH CY DE DK ES FI FR GB GR IE IT LI LU MC NL PT SE TR**<br>Designated Extension States:<br>**AL LT LV MK RO SI**<br><br>(30) Priority: **27.12.1999 US 472594**<br><br>(71) Applicant: **Nortel Networks Limited**<br>**Montreal, Quebec H2Y 3Y4 (CA)** | (72) Inventors:<br>• **Bisson, Robert L.**<br>**Kanata, Ontario K2L 2J2 (CA)**<br>• **McGinn, Scott S.**<br>**Ashton, Ontario K0A 1B0 (CA)**<br>• **Handforth, Martin R.**<br>**Kahton, Ontario K0A 1B0 (CA)**<br><br>(74) Representative: **Mackenzie, Andrew Bryan et al**<br>**Sommerville & Rushton,**<br>**45 Grosvenor Road**<br>**St Albans, Herts. AL1 3AW (GB)** |

(54) **A current sensing circuit and telephone line interface card with enhanced current sensing circuit**

(57)    An enhanced current sensing circuits, particularly suitable for use in telephony line interface cards is disclosed. The current sensing circuit includes a voltage sense circuit and sense amplifier that may be tuned for feed resistors of a given value to sense current through these feed resistors. Nominal values for the feed resistors are not required. A preferred voltage sense circuit includes a voltage dividing circuit connected across an impedance through which current is to be sensed. The voltage dividing circuit includes a tap to provide a voltage proportional to a voltage across the impedance, divided by a factor equal to a known multiple of the impedance. This sensed voltage may be determined without knowledge of the nominal value of the impedance and will be equal to a known fraction of the current through the impedance. A similar second voltage dividing circuit may be used to sense voltage and hence current through a second impedance. The sensed voltages may be combined to form a signal indicative of the current attributable to a differential voltage across the two impedances. Conveniently, the current sensing circuit facilitates manufacture of telephony line interface cards in which resistors used to drive a subscriber loop may not need to be trimmed to a nominal value.

**FIG. 3**

46

To loop

To Battery Supply

70a   50   72a

40, 110

70b   52   72b

-V

EP 1 126 281 A2

## Description

FIELD OF THE INVENTION:

The present invention relates to electrical circuits and more particularly to an enhanced current sensing circuit and a telephone line interface making use of such a circuit.

BACKGROUND OF THE INVENTION:

Many electrical applications require the accurate sensing of a current provided through an impedance. A simple way of measuring such a current is to measure a voltage drop across the impedance using a high-impedance measuring circuit. With knowledge of the value of the impedance, the current may easily be calculated from the measured voltage.

Often, current attributable to a differential voltage at the output of a pair of feed resistors is to be measured. For example, current provided through a telephone local subscriber loop as a result of a differential voltage signal at the output of resistors driving the loop may be so measured. Specifically, the current attributable to the differential signals passing through the loop may be measured by measuring the differential voltage across the feed resistors.

While effective, these methods of sensing current require feed resistances having precise nominal values. This, in turn, may require the use of costly, extremely accurately valued components.

Often the feed resistors are etched using resistive inks on a circuit board making it difficult to achieve the requisite nominal resistor values. Sometimes such etched resistors are serpentine in shape, designed to be robust to faults, caused, for example, by voltage surges. While laser trimming may be used to adjust the value of such etched resistors to desired nominal values, the resistors must be etched with a view to allow trimming. This, in turn, requires that the resistors occupy more area than necessary, potentially increasing the costs associated with the production and use of circuits using such resistors.

Accordingly, an improved method for sensing currents and particularly differential currents, reducing the dependence on precise nominal resistance values, and more generically impedance values, is desirable.

SUMMARY OF THE INVENTION

It is an object of the present invention to provide an enhanced current sensing circuit that is particularly well suited for use in a telephony line card.

In accordance with the present invention, a current sense circuit including a voltage sense circuit or sense amplifier is tuned for feed resistors having a given value to sense current through the feed resistors. Nominal values for the feed resistors are not required.

In accordance with the invention, a current sensing circuit for measuring a current attributable to a differential voltage' across a first and second impedance may be tuned. Such a current sensing circuit includes a voltage sense circuit for sensing the differential voltage; a differential amplifier connected with the voltage sense circuit to provide a signal proportional to the differential voltage. The circuit may be tuned by tuning at least one of the voltage sense circuit and the differential amplifier, so that an output of the differential amplifier provides the signal in known proportion to the differential voltage, and thereby provides a signal in known proportion to the current.

In accordance with another aspect of the present invention, current is sensed through an impedance using a sensing circuit that includes a voltage dividing circuit connected across the impedance. The voltage dividing circuit includes a tap to provide a voltage proportional to a voltage across the impedance, divided by a factor equal to a known multiple of the impedance. This sensed voltage may be determined without knowledge of the nominal value of the impedance and will be equal to a known fraction of the current through the impedance.

In accordance with another aspect of the invention, a current sensing circuit for sensing current due to a differential voltage across first and second impedances, includes a first voltage dividing circuit, for connection across the first impedance, and a second voltage dividing circuit, for connection across the second impedance. The first voltage dividing circuit includes a tap to provide a first voltage proportional to a voltage across the first impedance, divided by a factor equal to a known multiple of the first impedance. Similarly, the second voltage dividing circuit includes a tap to provide a second voltage proportional to a voltage across the second impedance, divided by a factor equal to the known multiple of the second impedance. A differentiating circuit is connected to the first voltage dividing circuit and the second voltage dividing circuit, to produce an output proportional to a difference of the first and second voltages, and thereby a signal equal to a known fraction of the current due to the differential voltage.

In accordance with another aspect of the invention, an impedance includes a body portion defining an impedance between first and second terminals. A voltage tap extends from the body portion between the first and second terminal to provide a sensed voltage proportional to a voltage between the terminals, divided by a factor equal to a known multiple of the impedance between the terminals.

Conveniently, such current sensing circuits facilitate manufacture of a telephony line interface card in which feed resistors used to drive an interconnected subscriber loop need not be trimmed to a nominal value. The value of the resistors may vary from manufactured card to card, while the circuit may be tuned to account for such variations.

Other aspects and features of the present invention will become apparent to those of ordinary skill in the art, upon review of the following description of specific embodiments of the invention in conjunction with the accompanying figures.

BRIEF DESCRIPTION OF THE DRAWINGS:

In figures, which illustrate by way of example, embodiments of the present invention:

FIG. 1 illustrates a conventional differential current sensing circuit;
FIG. 2 illustrates a conventional formation of a feed resistor;
FIG. 3 illustrates a line interface card, including an enhanced current sensing circuit exemplary of an embodiment of the present invention;
FIG. 4 illustrates the current sensing circuit of FIG. 3;
FIG. 5 illustrates the formation of an etched resistance pattern, including a current sense tap, exemplary of an embodiment of the present invention;
FIG. 6A illustrates a further current sensing circuit exemplary of an embodiment of the present invention; and
FIG. 6B illustrates a portion of the circuit of **FIG. 6A**.

DETAILED DESCRIPTION:

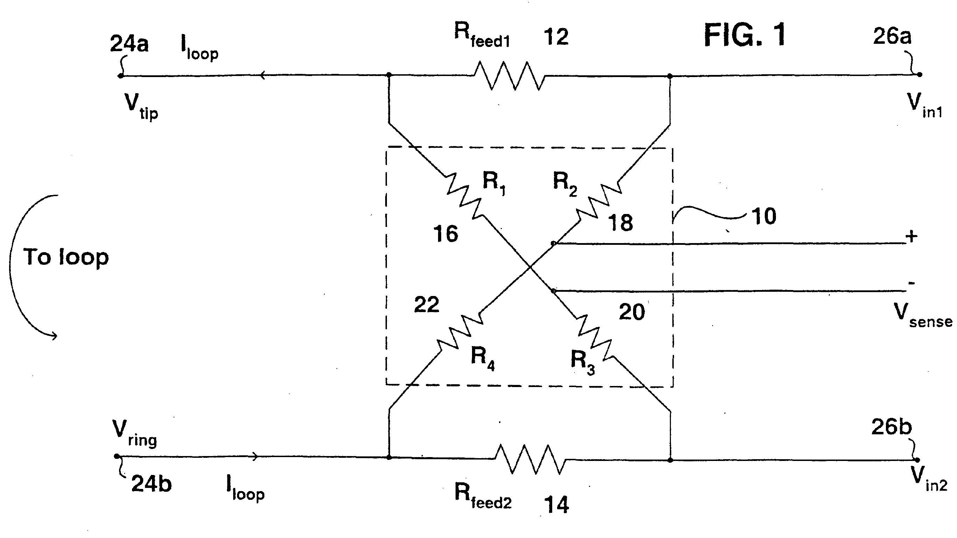

FIG. 1 illustrates a conventional voltage sensing circuit **10** configured to sense a differential voltage provided at output nodes **24a** and **24b** of feed resistor $R_{feed1}$ **12** and $R_{feed2}$ **14**. This sensed voltage is then used to determine a current attributable through $R_{feed1}$ **12** or $R_{feed2}$ **14** attributable to this differential voltage. As illustrated, sensing circuit **10** includes four sense resistors $R_1$ **16**, $R_2$ **18**, $R_3$ 20, and $R_4$ **22**. These resistors are connected as a bridge to form a differentiating circuit. $R_1$ **16** is connected in series with $R_3$ **20**. This series combination is connected between the input node **26b** of $R_{feed2}$ **14** and the output node **24a** of $R_{feed1}$ **12**. Similarly, the series combination of $R_2$ **18** and $R_4$ **22** is connected between input node **26a** of $R_{feed1}$ **12** and output node **24b** of $R_{feed2}$ **14**. The combinations of $R_2$ 18 and $R_4$ **22** and the node connecting $R_2$ **18** and $R_4$ **22** and the node connecting $R_1$ **16** and $R_3$ **20** provide a sensed voltage $V_{sense}$ to a differential sense amplifier (not shown in **FIG. 1**).

$R_{feed1}$ **12** and $R_{feed2}$ **14** may be the feed resistors of a telephone line interface card used to provide power to telephony equipment, interconnected with a subscriber loop provided to customer premises, at output nodes **24a** and **24b**. Nodes **24a** and **24b** are often referred to as "tip" and "ring" terminals, respectively.

Preferably, sense resistors $R_1$ **16,** $R_2$ **18,** $R_3$ **20** and $R_4$ **22** are at least an order of magnitude higher in value than feed and return resistors $R_{feed1}$ **12** and $R_{feed2}$

**14.** Typical values for $R_{feed1}$ **12** and $R_{feed2}$ **14** are 200 Ω. Sense resistors typically each have an identical resistance of 200 k Ω.

Input nodes **26a** and **26b** of $R_{feed1}$ **12** and $R_{feed2}$ **14** may be driven by a conventional power supply used to power such interconnected telephony equipment. Telephony signals are modulated onto the loop, as differential signals, as for example disclosed in U.S. Patent No. 5,333,192 and a U.S. Patent Application entitled "LINE INTERFACE CIRCUIT HAVING DUAL FEEDBACK NETWORKS", naming Scott McGinn and Robert Bisson, as inventors the contents of both of which are hereby incorporated by reference herein.

Differential signals are presented at nodes **24a** and **24b** in order to eliminate or limit the undesirable effects of common mode noise signals that may ignored or limited. Specifically, as wires forming the loop are often run in proximity to other signal carriers, such as power lines an identical (common-mode) current may be induced in both loop wires. Additionally, subscriber loop wires are adjacent to wires associated with other subscriber loops. The signal cross-talk that can occur between loops is in the form of common mode current.

Feed resistors $R_{feed1}$ **12** and $R_{feed2}$ **14** are used to limit surges on a subscriber loop such as those surges that may be caused by lightning and power faults.

Circuit **10**, (**FIG. 1**) may, for example, be used to sense current through feed resistors $R_{feed1}$ **12** and $R_{feed2}$ **14,** attributable to a differential voltage at output nodes **24a** and **24b**. As will be appreciated, this current may be sensed by sensing the differential voltage across $R_{feed1}$ **12** and $R_{feed2}$ **14**. By sensing such current and the associated differential voltage at nodes **24a** and **24b**, the input impedance at nodes **24a** and **24b** to a subscriber loop driven by $R_{feed1}$ **12** and $R_{feed2}$ **14** may be controlled using a feedback network. Example telephony line interface cards that may use circuit **10** are disclosed in U.S. Patent No. 5,333,192 and the aforementioned U.S. Patent Application.

Specifically, it may easily be shown that

$$V_{sense} = [(R_2/R_2+R_4)) *V_{in1} - (R_1/(R_1+R_3)) *V_{tip}] -$$

$$[(R_3/(R_1+R_3)) *V_{in2} - (R_4/(R_2+R_4)) *V_{ring}]$$

where $V_{in1}$ and $V_{in2}$ represent the voltages at input nodes **26a** and **26b**, respectively and $V_{tip}$ and $V_{ring}$ represent voltages at output nodes **24a** and **24b**, respectively.

Thus, if $R_2 = R_4$ and $R_1 = R_3$ then,

$$V_{sense} = \tfrac{1}{2} [V_{tip} - V_{in1}] - \tfrac{1}{2} [V_{ring} - V_{in2}]$$

That is, the sensed voltage, $V_{sense}$, is directly proportional to the differential voltage across resistors

$R_{feed1}$ **12** and $R_{feed2}$ **14,** and does not include the effect of any common mode voltage across either $R_{feed1}$ **12** or $R_{feed2}$ **14.**

From this, the current attributable to the differential signal across $R_{feed1}$ and $R_{feed2}$, $I_{sense}$, may be determined as $I_{sense} = V_{sense}/R_{feed1}$ provided that $R_{feed1} = R_{feed2}$. $V_{sense}$ may be provided to a sense amplifier having a known gain (ie. an output of known number of millivolts for each milliampere of current through $R_{feed1}$).

Thus, if values of $R_{feed1}$ **12** and $R_{feed2}$ **14** are accurately known, a fairly precise measurement of the current through $R_{feed1}$ **12** and $R_{feed2}$ **14** attributable to a differential voltage across these resistors may be obtained using current sensing circuit **10.**

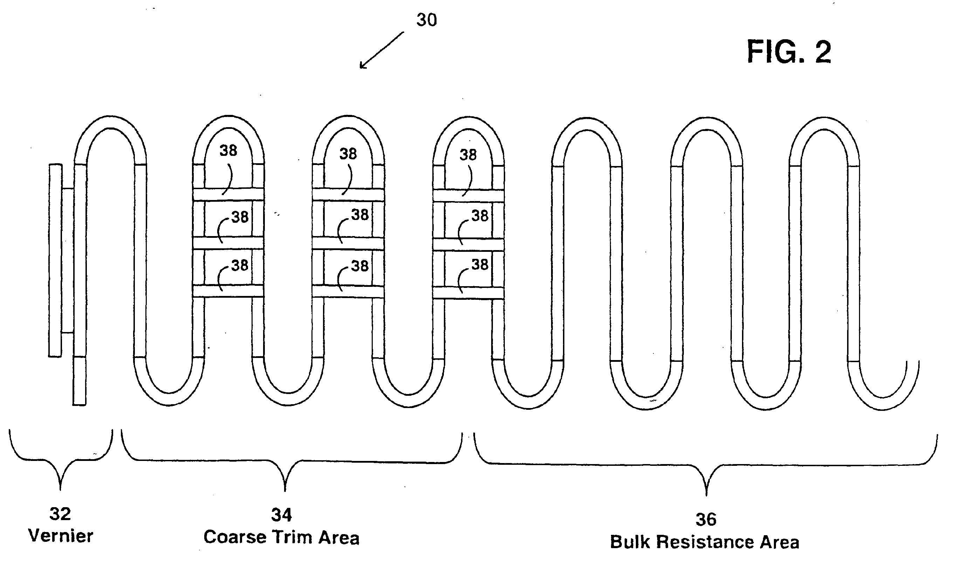

**FIG. 2** illustrates an exemplary serpentine resistance pattern **30** typically used to form $R_{feed1}$ **12** and $R_{feed2}$ **14** (FIG. 1) as part of a conventional telephony line card. Resistance pattern **30** is preferably etched using a resistive ink on a circuit board acting as a substrate, and forming the telephony line card. Each resistance pattern **30** preferably includes a vernier **32** (fine trim area); coarse trim area **34;** and bulk resistance area **36**. A plurality of shorting links **38** allows for the adjustment of the resistance of coarse trim area **34**. By cutting any of the bottom shorting links **38**, the length of coarse trim area **34**, and hence its resistance and the resistance of pattern **30** is increased. Sequential cutting of additional bottom shorting links **38** allows for the additional adjustment of resistance of pattern **30.** Each of links **38** that is cut results in a step increase in the resistance of pattern **30**. Vernier **32** may be trimmed to incrementally adjust the resistance of pattern **30** in an amount less than the step increase effected by each link. Vernier **32** may be trimmed using conventional laser cuts. Because of the relatively low resistance value of vernier **32**, cuts in vernier **32** are not particularly sensitive to high voltage currents. Thus, by cutting links **38** and trimming vernier **32,** the resistance of pattern **30** may be adjusted to a desired nominal, predetermined value so that current through it may easily be sensed, using circuit **10** of **FIG. 1.**

Typically, in order to ensure a desired resistance value for $R_{feed1}$ **12** and $R_{feed2}$ **14,** serpentine resistance pattern **30** is trimmed after manufacture by laser cutting one or more of shorting links **38** thereby lengthening the effective end to end length of the serpentine resistance pattern **30**, so that it assumes a desired nominal value. In order to withstand lightning and power cross faults, resistance pattern **30** is, however, typically designed and etched with the assumption that, in some cases, no shorting link **38** will be cut. In such cases, the entire surge is absorbed in bulk resistance area **36**. Thus, bulk resistance area **36** typically assumes the majority of the surface area of resistance pattern **30**. For example, bulk resistance area **36** usually occupies about 56% of the area of resistance pattern **30**; coarse trim area **34**, 34%; and vernier **32**, 10%. This accordingly requires that the size of the substrate on which the resistance pattern **30** is etched be of an increased size. Clearly, by eliminating or reducing the size of coarse trim area **34**, the overall area occupied by resistance pattern **30** may be reduced.

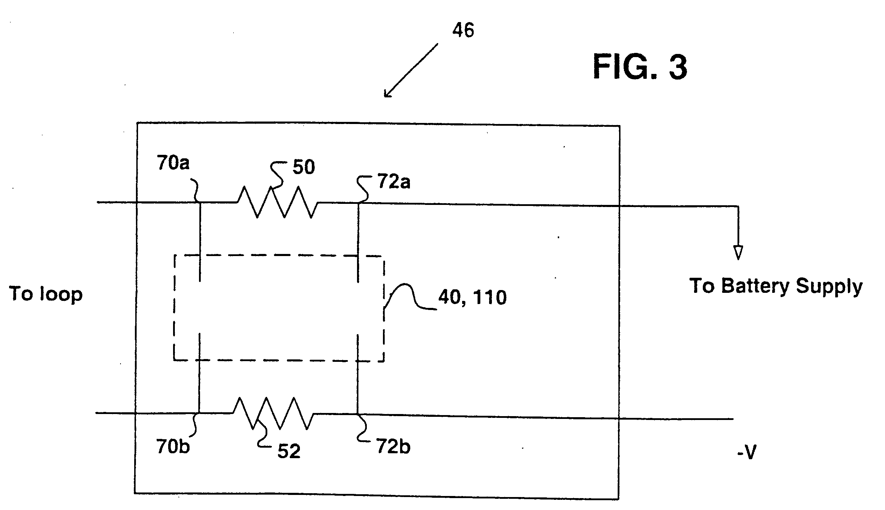

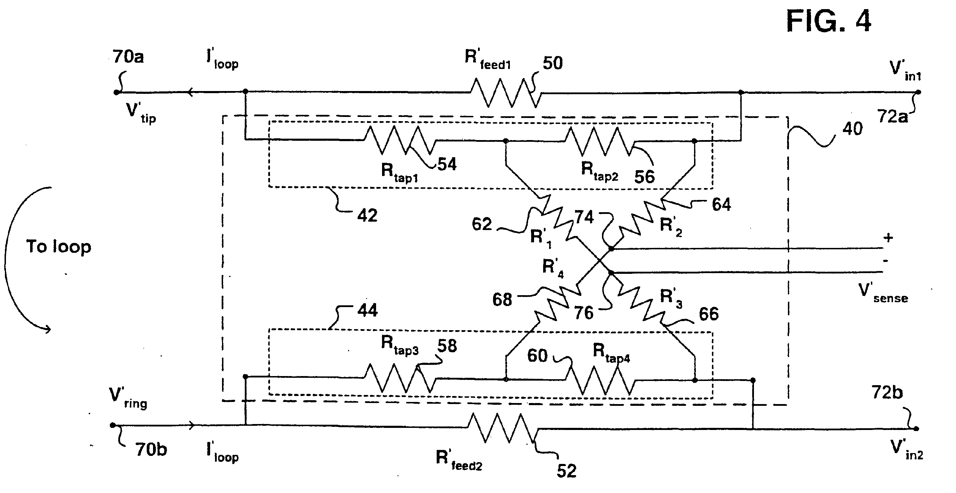

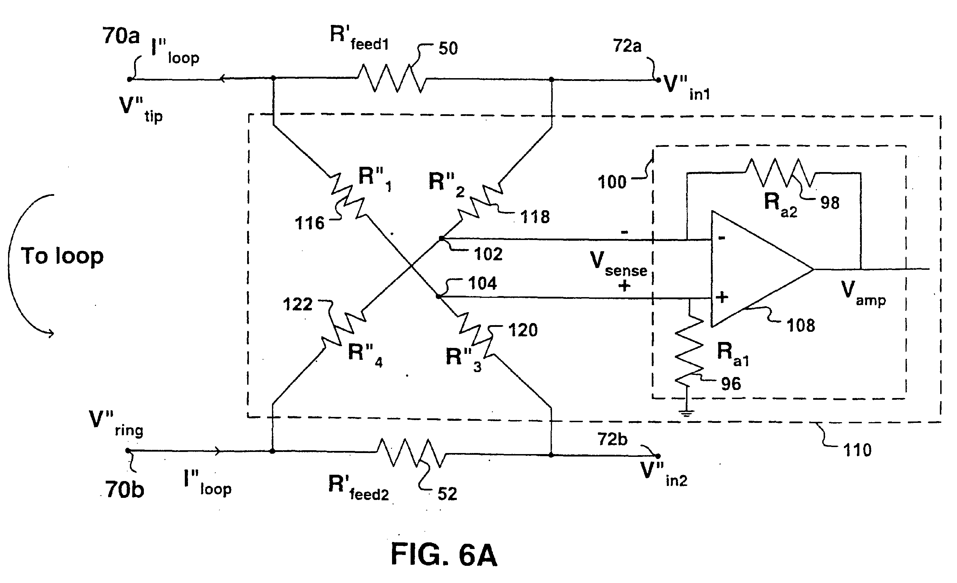

Conveniently then, **FIG. 3** illustrates a line interface card **46**, including an enhanced voltage sensing circuit **40** or circuit **110,** each exemplary of an embodiment of the present invention. Sensing circuit **40** is illustrated in FIG. **4**. Sensing circuit **110** is illustrated in **FIG. 6A**.

As illustrated in **FIG. 4**, circuit **40** may be used to sense a differential voltage across feed resistors R'$_{feed1}$ **50** and R'$_{feed2}$ **52** and hence a current attributable to differential voltage signals V'$_{tip}$ and V'$_{ring}$ at nodes **70b** and **70b** provided through feed resistors R'$_{feed1}$ **50** and R'$_{feed2}$ **52**. As with the voltage sensing circuit **10** of **FIG. 1**, current sensing circuit **40** of **FIG. 4** includes four sense resistors R'$_1$ **62,** R'$_2$ **64,** R'$_3$ **66,** and R'4 **68,** acting as a differentiating circuit. Additionally, circuit 40 includes two voltage dividing circuits **42** and **44,** each including two tap resistors $R_{tap1}$ **54,** Rt$_{ap2}$ **56,** and $R_{tap3}$ **58,** $R_{tap4}$ **60,** respectively.

As illustrated, instead of being connected directly across the resistors through which current is to be sensed, the differentiating circuit including sense resistors R'$_1$ **62,** R'$_2$ **64,** R'$_3$ 66 and R'$_4$ **68** are connected to voltage dividing circuits 42 and **44** across $R_{tap2}$ **56** and $R_{tap4}$ **60**. The series combination of $R_{tap1}$ **54** and $R_{tap2}$ **56** is connected across R'$_{feed1}$ **50**. Similarly, the series combination of $R_{tap3}$ **58** and $R_{tap4}$ **60** is connected across R'$_{feed2}$ **52.**

As further illustrated, a further first series combination of R'$_1$ **62** and R'$_3$ **66** is connected to the end of $R_{tap4}$ **60** that is connected to input node **72b**. The opposite end of the first series combination is connected to an end of $R_{tap2}$ **56** that is connected to $R_{tap1}$ **54**. Similarly, a second series combination of R'$_2$ **64** and R'$_4$ **68** is connected between the end of $R_{tap2}$ **56** connected to $R_{tap1}$ **54** and the end of $R_{tap4}$ **60** connected to input terminal **72b.**

As such V'$_{sense}$, the output of sensing circuit **40** at terminals **74** and **76** provided to a sense amplifier, will equal

$$V_{sense} = \tfrac{1}{2} \, [V_{rtap2} - V_{rtap4}],$$

where $V_{rtap2}$ and $V_{rtap4}$ are the voltage drops across $R_{tap2}$ **56** and $R_{tap4}$ **60,** respectively.

Conveniently, as the series combination of $R_{tap1}$ **54** and $R_{tap2}$ **56** forms a voltage divider connected across feed resistor $R_{feed1}$,

$$V_{rtap2} = V_{feed} * R_{tap2} / (R_{tap1} + R_{tap2}) \, .$$

Similarly,

$$V_{rtap4} = V_{feed} * R_{tap4} / (R_{tap3} + R_{tap4})$$

where $V_{feed}$ represents the voltage across feed resistor $R_{feed1}$.

More conveniently then, if $|R_{tap2}/(R_{tap1} + R_{tap2})| = |1/R_{feed1}|$, and

$$|R_{tap4}/ (R_{tap3} + R_{tap4}) | = |1/R_{feed2}|,$$

then

$$| V'_{sense} | = | I'_{sense} |,$$

where $I'_{sense}$ represents the current attributable to a differential voltage across either $R'_{feed1}$ **50** or $R'_{feed2}$ **52** and at nodes **70a** and **70b.**

As should now be apparent, use of circuit **40** allows measurement of the desired current $I'_{sense}$ using the same sense amplifier used with the circuit **10**, without requiring knowledge of the nominal value of $R'_{feed1}$ **50** and $R'_{feed2}$ **52** provided that voltage sense circuit **40** including voltage dividing circuits **42** and **44** is properly matched to $R'_{feed1}$ **50** and $R'_{feed2}$ **52**.

Thus, use of voltage sensing circuit **40** in association with $R'_{feed1}$ **50** and $R'_{feed2}$ **52** may be extremely convenient. As current through $R_{tap1}$ **54,** $R_{tap2}$ **56,** $R_{tap3}$ **58** and $R_{tap4}$ **60,** is low, these may be formed as low power rectilinear resistors, that may be etched on a relatively small substrate. Moreover, these low-power resistances may be easily adjusted through laser trimming. During manufacture, one of $R'_{feed1}$ **50** and $R'_{feed2}$ **52** may be measured and laser trimmed to be equal in value to the other one of $R'_{feed1}$ **50** and $R'_{feed2}$ **52**. As neither $R'_{feed1}$ **50** nor $R'_{feed2}$ **52** needs to be trimmed to a nominal value, a coarse trim area, such as coarse trim area **34** is not necessarily required. As both $R'_{feed1}$ **50** and $R'_{feed2}$ **52** are formed during the same manufacturing process, their value will typically not differ by much from each other. As such, only a much smaller fine trim area will typically be necessary. This single fine trim area need only occupy 10% of the space occupied by the etched resistors $R'_{feed1}$ **50** and $R'_{feed2}$ **52.** Moreover without a need for coarse trim area **34,** $R'_{feed1}$ **50** and $R'_{feed2}$ **52** could be formed as rectilinear etched resistors.

Once $R'_{feed1}$ **50** or $R'_{feed2}$ **52** is trimmed voltage sense circuits **42** and **44** may be tuned. $R_{tap1}$ **54,** $R_{tap2}$ **56,** $R_{tap3}$ **58,** and $R_{tap4}$ **60** may be measured, $R_{tap2}$ **56** and $R_{tap4}$ **60** may be laser trimmed so that

$$| R_{tap2}/ (R_{tap1} + R_{tap2}) | = |1/R'_{feed1}|; \text{ and}$$

$$|R_{tap4}/ (R_{tap3} + R_{tap4}) | = |1/R'_{feed2}|.$$

Alternatively, $R_{tap1}$ **54,** $R_{tap2}$ **56,** $R_{tap3}$ **58** and $R_{tap4}$ **60** may be laser trimmed so that

$$|R_{tap2}/(R_{tap1} + R_{tap2}) | = K | 1/K*R'_{feed1}|; \text{ and}$$

$$|R_{tap4}/ (R_{tap3} + R_{tap4}) | = |1/K*R'_{feed2} |,$$

where K is some known multiple.

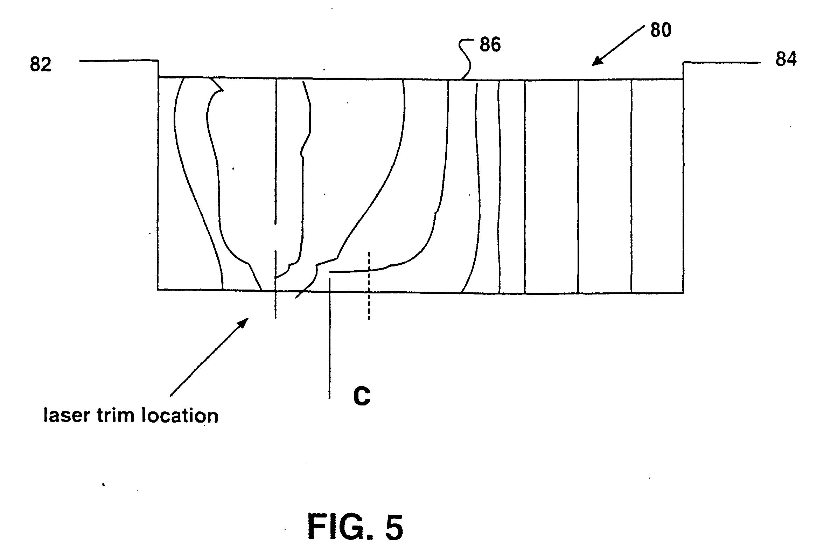

More conveniently, the series combination of $R_{tap1}$ **54** and $R_{tap2}$ **56** and the series combination of $R_{tap3}$ **58** and $R_{tap4}$ **60** may be entirely eliminated by choosing an appropriate laser trim on a rectilinear resistor **80,** used to form $R'_{feed1}$ **50** or $R'_{feed2}$ **52** of **FIG. 4** as illustrated in **FIG. 5**. Specifically, resistor **80** may etched on a substrate using a resistive ink, and may then be trimmed to a desired resistance. Thereafter a resistance at a sensepoint C located on body portion **86** between terminals **82** and **84** (corresponding to input **72a** and output **70a** for $R'_{feed1}$ **50;** input **72b** and output **70b** for $R'_{feed2}$ **52),** may be adjusted so that the voltage at sensepoint C equals the voltage across the resistor **80,** divided by some known multiple of the resistance between terminals **82** and **84**. Thus, resistor **80** effectively includes its own voltage dividing circuit, equivalent to voltage dividing circuit **42** or **44**. As should be appreciated, resistance at sensepoint C may be adjusted by conventional laser trims along the body portion **86**. Specifically, by iteratively trimming body portion **86** on one or both sides of sensepoint C, the overall resistance of resistor **80** may be adjusted, and the relative voltage at sensepoint C may be adjusted. Once the voltage at sensepoint C is adjusted, it may be connected by way of sense resistors, such as resistors $R'_1$ **62**, $R'_2$ **64**, $R'_3$ **66** and $R'_4$ **68** (**FIG. 4**) to one of the inputs of a differential sense amplifier.

Sense resistors $R'_1$ **62**, $R'_2$ **64**, $R'_3$ **66** and $R'_4$ **68** may similarly be formed as etched low power rectilinear resistors. In order to assure that sensing circuit **40** may be used with a sense amplifier identical to that used in association with current sensing circuit **10 (FIG.** 1), $R'_1$ **62,** $R'_2$ **64,** $R'_3$ **66** and $R'_4$ **68** of circuit **40** may be trimmed so that the input impedance at the sense amplifier used in association with circuit **40** is identical to that of circuit **10**. A person of ordinary skill in the art will readily appreciate that this may be accomplished by trimming $R'_1$ **62**, $R'_2$ **64,** $R'_3$ **66** and $R'_4$ **68** so that the Thevenin equivalent resistance as sensed at terminals **74** and **76** is the same as the Thevenin resistance at the sense terminals of circuit **10**. This may, for example, be accomplished by shorting terminals **70a** and **70b**; grounding terminals **72a** and **72b**; measuring the input impedance at terminals **74** and **76**, and trimming $R'_1$ **62**, $R'_2$ **64**, $R'_3$ **66** and $R'_4$ **68** to provide the desired nominal Thevinin input impedance.

Alternatively, the sense amplifier may be buffered so that the impedance of sensing circuit **40** does not affect the ultimate output of an interconnected sense amplifier.

As may now be appreciated, the above sense resistors are trimmed so that a sense amplifier generates a nominal output in proportion to the current attributable to the differential voltages across $R'_{feed1}$ **50** and $R'_{feed2}$ **52.** Voltage sense circuit **40** formed in part by $R_{tap1}$ **54,** $R_{tap2}$ **56,** $R_{tap3}$ **58** and $R_{tap4}$ **60** is tuned so that the differential voltage provided to a sense amplifier is isolated from the actual nominal values of the $R'_{feed1}$ **50** and $R'_{feed2}$ **52.**

However, as illustrated with reference to voltage sensing circuit **110** in **FIG. 6A**, the effects of resistance variations in $R'_{feed1}$ **50** and $R'_{feed2}$ **52** of **FIGS. 3** and **4** could be compensated for by tuning the differential amplifier **100,** used to provide an output proportional to the sensed differential voltage at terminals **102** and **104.** The voltage sense circuit **110** of **FIG. 6A** is substantially identical to that illustrated in **FIG. 1.** It includes sense resistors $R''_1$ **116,** $R''_2$ **118,** $R''_3$ **120,** and $R''_4$ **122** connected in a bridge across $R'_{feed1}$ **50** and $R'_{feed2}$ **52** and thereby sensing voltage across $R'_{feed1}$ **50** and $R'_{feed2}$ **52.** Further illustrated in **FIG. 6A** is a differential sense amplifier **100** (not specifically illustrated in **FIGS. 1, 3** or **4**).

Example differential amplifier **100** includes a conventional operational amplifier **108,** having resistor $R_{a2}$ **98** connected between its output and inverting input, and resistor $R_{a1}$ **96** connected between its non-inverting input and ground.

As illustrated in **FIG. 6A,** and as detailed with reference to **FIG. 1,** the differential voltage sensed at terminals **102** and **104** and presented at the inputs of amplifier **108** equals

$$\tfrac{1}{2}\,[V''_{tip} - V''_{in1}] - \tfrac{1}{2}\,[V''_{ring} - V''_{in2}],$$

assuming that $R''_1 = R''_3$ and $R''_2 = R''_4$.

In order to achieve an output that is a known multiple of the current attributable to differential voltages at nodes **70a** and **70b** at amplifier **108,** the gain of amplifier **100** may be adjusted by adjusting amplifier resistors $R_{a1}$ **96** and $R_{a2}$ **98** so that the output of amplifier **108** equals the current through $R'_{feed1}$ **50** or $R'_{feed2}$ **52,** scaled by a known factor K. Thus, trimming $R_{a1}$ **96** and $R_{a2}$ **98** so that the output of differential amplifier **108** presents a gain of $K/R'_{feed1}$, a nominal value of $R'_{feed1}$ **50** and $R'_{feed2}$ **52** is not required.

That is, provided amplifier **108** is tuned so that its output voltage, $V_{amp}$, equals,

$$K/R''_{feed1}\,{}^*\{\tfrac{1}{2}\,[V_{tip} - V_{in1}] - \tfrac{1}{2}\,[V_{ring} - V_{in2}]\}.$$

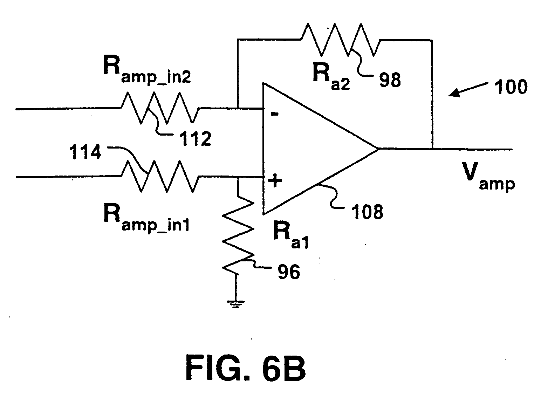

For clarification, the amplifier of **FIG. 6A** is again illustrated in **FIG. 6B.** The resistance presented at its inputs as result of interconnection with sense circuit **110**, are modelled as resistors $R_{amp\_in1}$ **112** and $R_{amp\_in2}$ **114**. It may be easily illustrated that the amplifier of **FIG. 6B** acts as a differential amplifier when

$$R_{a1}/R_{amp\_in1} = R_{a2}/R_{amp\_in2}.$$

Moreover, its output may be shown to equal

$$V_{amp} = R_{a2}/R_{a1}\,{}^*V_{sense}.$$

Further $R_{amp\_in1}$ **112** and $R_{amp\_in2}$ **114** of **FIG. 6B** actually represent the Thevenin resistances at terminals **102** and **104** of **FIG. 6A**.

Accordingly, circuit **110** of **FIG. 6A** is preferably formed by first measuring $R'_{feed1}$ **50;** trimming $R'_{feed2}$ **52** to have an identical value; trimming $R''_1$ **116,** $R''_2$ **118,** $R''_3$ **120** and $R''_4$ **122** to have equivalent values and to present a fixed input impedance at terminals **102**, and **104**. As noted, with reference to **FIG. 4**, this may be accomplished by shorting terminals **70a** and **70b**, and measuring the input impedance to ground at terminals **102** and **104**.

Thereafter, $R_{a1}$ **96** and $R_{a2}$ **98** may be trimmed so that $R_{a2}/R_{amp\_in1} = R_{a1}/R_{amp\_in2}$, and $R_{a2}/R_{a1} = K/R''_{feed1}$.

Then

$$V_{amp} = K/R''_{feed1}\,{}^*V_{sense}$$

providing the desired output at amplifier **100.**

As will be appreciated, as $R'_{feed1}$ **50** and $R'_{feed2}$ **52** need only be equal to each other, they need not be greatly trimmed. They may thus be formed as rectilinear resistors, reducing the area occupied by $R'_{feed1}$ **50** and $R'_{feed2}$ **52.** Moreover, $R''_1$ **116,** $R''_2$ **118,** $R''_3$ **120,** $R''_4$ **122,** $R_{a1}$ **96** and $R_{a2}$ **98** may all be formed as low power rectilinear resistors, and trimmed to have the desired/ required values.

As should now be understood, any differential gain stage adjusted so that its output is proportional to the differential voltage sensed across $R'_{feed1}$ **50** or $R'_{feed2}$ **52** in some known manner may achieve the same result. So, a further amplifier tuned to provide a net output in proportion to the sensed voltage could be connected in series with the output of the amplifier of **FIG. 1.** Numerous other ways to tune the amplifier and sense circuit will be understood by those of ordinary skill in the art. Similarly, a person skilled in the art will readily appreciate any number of circuits that may be used to output a signal representative of a differential voltage across feed resistors $R'_{feed1}$ **50** and $R'_{feed2}$ **52.**

While the above described embodiments, have been described in the context of resistance values, a person skilled in the art will readily appreciate that the invention may be easily applied to generalised impedances including capacitive and inductive components. Similarly, while etched resistors have been described as being etched using a resistive ink, a person skilled in the art will readily appreciate that similar resistance patterns may be etched using other resistive materials properly placed on a substrate. Moreover, while feed resistors $R'_{feed1}$ **50**, $R'_{feed2}$ **52,** have been illustrated as preferably being formed as rectilinear resistors, they may be formed as serpentine or other resistors.

The above described embodiments are intended to be illustrative only, and in no way limiting. The embodiments are susceptible to many modifications of form, size, arrangement of parts and details of operation. The invention, rather, is intended to encompass all such modifications within its scope as defined by the claims.

**Claims**

1. A sensing circuit for measuring current through an impedance, comprising:
   a voltage dividing circuit, for connection across said impedance, said voltage dividing circuit comprising a tap to provide a voltage proportional to a voltage across said impedance, divided by a factor equal to a known multiple of said impedance.

2. The sensing circuit of claim 1, wherein said known multiple equals one.

3. The sensing circuit of claim 2, wherein said voltage dividing circuit comprises:
   a first tap impedance connected in series with a second tap impedance and connected across said impedance, wherein a value of a ratio of said sum of said first tap impedance and said second tap impedance to said first tap impedance equals a value of said impedance.

4. The sensing circuit of claim 0, wherein said impedance comprises a resistance.

5. The sensing circuit of claim 4, wherein said resistance comprises an etched pattern on a substrate.

6. The sensing circuit of claim 5, wherein said first tap impedance comprises a resistance formed as a second etched pattern on said substrate, and said second tap resistance comprises a resistance formed as an third etched pattern on said substrate.

7. The sensing circuit of claim 4, wherein said etched pattern is generally rectilinear.

8. A sensing circuit for sensing current due to a differential voltage across first and second impedances, said sensing circuit comprising:

   a first voltage dividing circuit, for connection across said first impedance, said first voltage dividing circuit comprising a tap to provide a first voltage proportional to a voltage across said first impedance, divided by a factor equal to a known multiple of said first impedance;

   a second voltage dividing circuit, for connection across said second impedance, said second voltage dividing circuit comprising a tap to provide a second voltage proportional to a voltage across said second impedance, divided by a factor equal to said known multiple of said second impedance;

   a differentiating circuit, connected to said first voltage dividing circuit and said second voltage dividing circuit, to produce an output proportional to a difference of said first voltage and said second voltage.

9. The current sensing circuit of claim 8, wherein said known multiple equals one.

10. The sensing circuit of claim 8, wherein said first voltage dividing circuit comprises:
    a first tap impedance connected in series with a second tap impedance and connected across said first impedance, wherein a value of a ratio of said sum of said first tap impedance and said second tap impedance to said first tap impedance equals a value of said first impedance.

11. The sensing circuit of claim 10, wherein said second voltage dividing circuit comprises:
    a third tap impedance connected in series with a fourth tap impedance and connected across said second impedance, wherein a value of a ratio of said sum of said third tap impedance and said fourth tap impedance to said third tap impedance equals a value of said second impedance.

12. The sensing circuit of claim 11, wherein said differentiating circuit comprises:
    a bridge circuit comprising:

    first, second third and fourth sense resistors;

    said first and third sense resistors connected in series to form a first series combination, said first series combination connected between

    i) an end of said first tap impedance that is connected to said second tap impedance; and

    ii) an end of said fourth tap impedance that is connected to said second impedance;

said second and fourth sense resistors connected in series to form a second series combination, said second series combination connected between

    i) an end of said third tap impedance that is connected to said fourth tap impedance; and

    ii) an end of said first tap impedance that is connected to said second impedance.

13. The sensing circuit of claim 12, wherein said first, second, third and fourth sense resistors are equal to each other.

14. A telephony line interface card, including a sensing circuit as claimed in claim 8.

15. An impedance comprising,

    a first terminal;

    a second terminal;

    a body portion defining an impedance between said first terminal and said second terminal;

    a voltage tap on said body portion, between said first terminal and said second terminal to provide a sensed voltage proportional to a voltage between said first terminal and said second terminal, divided by a factor equal to a known multiple of said impedance between said first and second terminals.

16. The impedance of claim 15, wherein said body portion is formed as an etched pattern on a substrate.

17. The impedance of claim 16, wherein said etched pattern is generally rectilinear.

18. The impedance of claim 17, wherein said voltage tap is located at a position along a length of said body portion to provide said sensed voltage proportional to said voltage between said first terminal and said second terminal, divided by a factor equal to said impedance between said first and second terminals.

19. The impedance of claim 15, wherein said known multiple equals one.

20. A telephony line interface card, comprising an impedance as claimed in claim 15.

21. A method of tuning a current sensing circuit for measuring a current attributable to a differential voltage across a first and second impedance, said current sensing circuit comprising:

    a voltage sense circuit for sensing said differential voltage;

    a differential amplifier connected with said voltage sense circuit to provide a signal proportional to said differential voltage;

    said method comprising:
    tuning at least one of said voltage sense circuit and said differential amplifier, so that an output of said differential amplifier provides said signal in known proportion to said differential voltage, and thereby provides a signal in known proportion to said current.

22. The method of claim 21, wherein a gain of said differential amplifier is adjusted so that said differential amplifier provides a signal in known proportion to said differential voltage.

23. The method of claim 22, wherein said amplifier comprises an operational amplifier, and said gain is adjusted by adjusting a feedback resistor between an input and output of said operational amplifier.

24. The method of claim 23, wherein said gain of said amplifier is based on a value of one of said first impedance and said second impedance.

25. The method of claim 24, wherein said adjusting comprises measuring one of said first impedance and said second impedance.

26. A telephony line interface card, including a current sensing circuit tuned in accordance with the method of claim 21.

FIG. 1

EP 1 126 281 A2

**FIG. 2**

30

38  38  38

38  38  38

38  38  38

32
Vernier

34
Coarse Trim Area

36
Bulk Resistance Area

EP 1 126 281 A2

FIG. 3

46

70a    50    72a

To loop

40, 110

To Battery Supply

70b    52    72b

-V

EP 1 126 281 A2

FIG. 4

EP 1 126 281 A2

**FIG. 5**

laser trim location

FIG. 6A

**FIG. 6B**